Europäisches Patentamt

European Patent Office

Office européen des brevets

(19)

(11) Publication number : **0 489 571 A2**

(12) **EUROPEAN PATENT APPLICATION**

(21) Application number : **91311246.2**

(22) Date of filing : **03.12.91**

(51) Int. Cl.⁵ : **G01R 31/28**

(30) Priority : **04.12.90 US 622695**

(43) Date of publication of application :
**10.06.92 Bulletin 92/24**

(84) Designated Contracting States :
**DE FR GB NL**

(71) Applicant : **Xilinx, Inc.**
**2100 Logic Drive**
**San Jose, California 95124 (US)**

(72) Inventor : **Parlour, David B.**
**4231 Parkman Avenue**
**Pittsburgh, Pennsylvania (US)**
Inventor : **Goetting, F. Erich**
**11659 Olive-Spring Court**
**Cupertino, California (US)**

(74) Representative : **W.P. THOMPSON & CO.**
**High Holborn House, 52-54 High Holborn**
**London WC1V 6RY (GB)**

(54) **Estimating resistance and delay in an integrated circuit structure.**

(57) In a configurable logic array chip having elements interconnectable by antifuses, an antifuse test structure is provided for estimating speed and resistance of programmed antifuses in the logic array without sacrificing any of the antifuses available for programming by the end user. Antifuses programmable by the same means as those in the logic array are selectively programmed to form a test path having characteristics representative of a path formed by a user in the logic array. A signal is propagated along this test path and time delay for propagation tested by switching the signal at a rate equal to a maximum acceptable time delay, then determining whether the signal propagates through the test path within the time before the signal switches. In a preferred embodiment, the antifuse test structure is located along edges of the configurable logic array chip and each edge of the chip tested for acceptable delay.

FIGURE 1

EP 0 489 571 A2

This application relates to the estimation of resistance and delay in an integrated circuit structure and is related to European Application having the application date of 3 December 1991 and claiming priority from US Patent Application Serial No. 07/625 732 entitled "Structure and Method of Programming Antifuses in an Integrated Circuit Array". European Application and US Application 07/625 732 are incorporated herein by reference.

Logic elements in an integrated circuit configurable logic array may be programmably interconnected through antifuses positioned to interconnect line segments in the array. Some of the line segments lead to input and output ports of the logic elements and some of the line segments connect to externally accessible pins of the logic array package. When the line segments are interconnected by means of antifuses, it is not possible to test each of the antifuses for final programmed resistance before shipping the part to a customer, since antifuses, once programmed, cannot be unprogrammed. Yet it is important to be able to guarantee to a customer what resistance can be expected in a programmed antifuse. Manufacturing processes for integrated circuit structures are complex, involving many steps and requiring precise manufacturing conditions. It has been found that final resistance of a programmed antifuse varies from one manufacturing facility to another, from wafer to wafer, and even from chip to chip depending on the precise processing parameters and quality of materials used. Therefore if the manufacturer is to guarantee performance of a particular logic array chip to a customer, the manufacturer must be able to reliably estimate the resistance to be expected when antifuses of that logic array chip are programmed.

According to the present invention, an integrated circuit chip which is to be programmed by a customer using antifuses is provided with an antifuse test structure having characteristics similar to portions of the integrated circuit. Before the integrated circuit chip is shipped to the customer, it is tested by programming selected antifuses in the test structure to form a test path, propagating a signal along the test path, and determining whether time delay along the test path is small enough to be acceptable. In a preferred embodiment, antifuse test structures are formed along each edge of the integrated circuit chip and serially connected. Acceptable time delay is evaluated along each edge. The chip is then rated according to time delay along the slowest edge. One structure and method for evaluating time delay applies an original square wave input signal to the input port of a flip flop and applies the input signal as delayed by the test path to the clock port. The period of the square wave is selected to be twice the acceptable time delay of the test path. Thus the square wave signal remains in a logic low state for the maximum acceptable test path delay time and also remains in a logic high state for the maximum acceptable test path delay time. If the actual test path delay is within the maximum acceptable value, the flip flop outputs a given value, for example a D-flip flop with a clock trigger on a rising edge will output a low signal to indicate an acceptable delay and a high signal to indicate an unacceptable delay.

The four edges of the chip may be evaluated in parallel by feeding output of the flip flops positioned on the four edges to a five-input logic gate, with the original signal applied to the fifth input. For example, the signals can be applied to a five input NOR gate. Low signals on four acceptable paths will allow the original square wave to be propagated by the NOR gate. A high signal from any of the flip flops will produce a steady low output signal indicating a failed time delay test.

For serially connecting successive edges and evaluating whether all edges of the chip have acceptable time delay, the flip flop output is used to determine whether the switching input signal is passed to the next edge. For example, the Q output of a D-flip flop triggered on the rising edge of a clock signal is combined by an OR gate (or a NOR gate plus an inverter) with the original signal. If the Q output is low, indicating acceptable delay, the switching undelayed signal is passed to the antifuse test structure on the next edge of the chip. Only if test structures on all edges of the ship have acceptable delays will the output signal from the last edge of the chip be a switching signal.

Increasing the rate at which the signal switches decreases the acceptable time delay. In one method embodiment, switching begins at a rate which is the lowest rate acceptable for any standard, and increases until the output signal from the test structure no longer follows the input signal but is a constant value. Chips car thus be sorted according to switching rate at which the output signal becomes a constant value. This rate relates to estimated antifuse programmed resistance and circuit delay. Chips can be sold accordingly.

The invention is further described below, by way of example, with reference to the accompanying drawings, in which:

Fig. 1 shows a speed testing circuit according to a preferred embodiment of the invention.

Fig. 2 shows variation in resistance of programmed antifuses manufactured by the same manufacturing process, as a function of programming current.

Fig. 3 shows a circuit for programming antifuses used in the speed testing circuit of Fig. 1 and in a configurable logic array chip in which the speed testing circuit is incorporated.

Fig. 4 shows a circuit for addressing pumped decoders used in the circuit of Fig. 3 for causing programming voltages to be applied to antifuses in the speed testing circuit and in the configurable logic array of the chip.

## Speed Testing Circuit

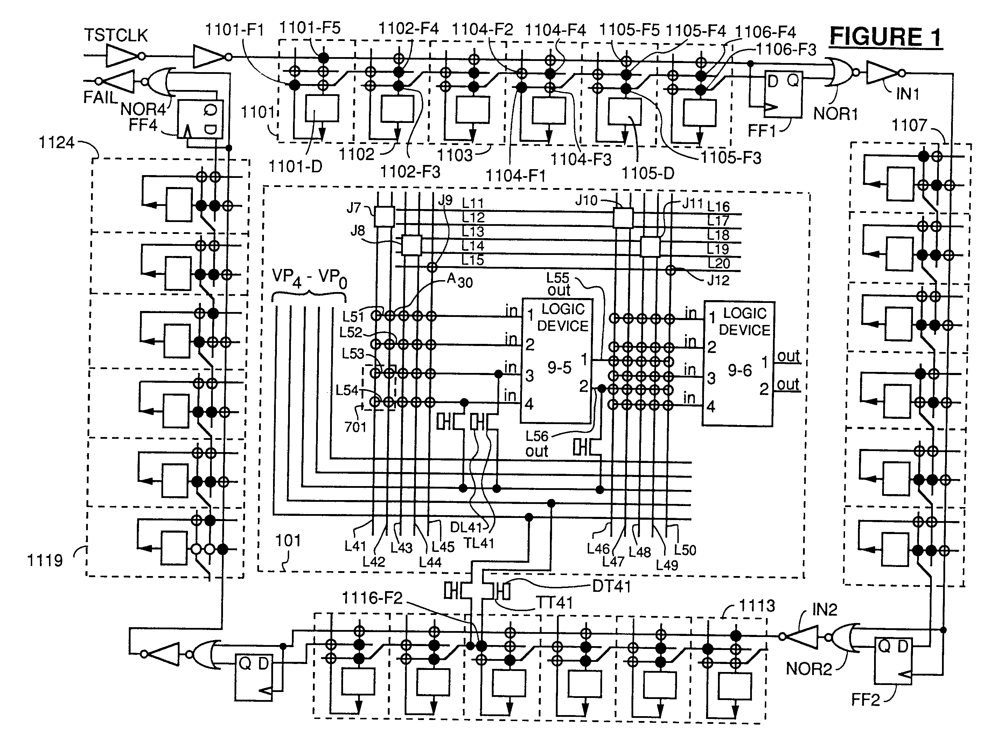

In a preferred embodiment, a test structure having a set of antifuses arranged as shown at the perimeter of Fig. 1 is provided in a user-programmable logic array chip for the purpose of testing speed, programmability, and resistance of antifuses in the user-programmable chip. A higher resistance in the antifuses of a signal path will of course result in a slower circuit, due to the RC product (resistance times capacitance) of elements in the signal path.

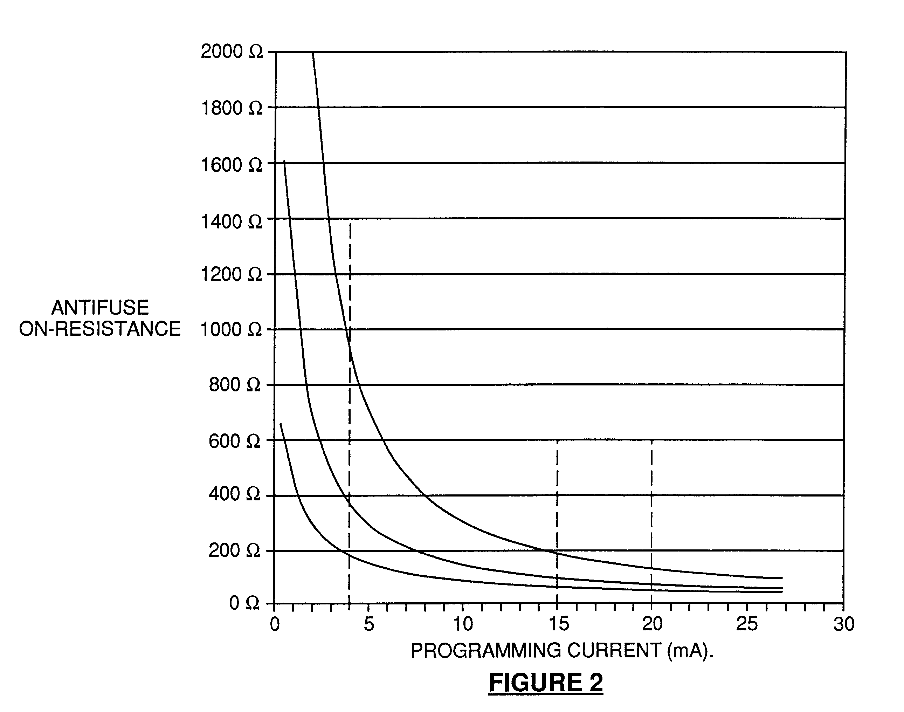

Variation in programmed resistance of antifuses manufactured by the same manufacturing process is illustrated by the spread between the curves of Fig. 2. Variation in resistance from one antifuse to another for a given programming current results from such factors as small variations in thickness of the antifuse material and precise composition of the antifuse material. This variation may be significant from one wafer to another, as can be seen in Fig. 2. It has also been found that there is some variation in programmed resistance across a single chip. However, the resistance variation across a single chip is small compared to the resistance variation from wafer to wafer or from manufacturing site to manufacturing site. Thus a benefit in estimating resistance of a programmed antifuse can be achieved by including on the chip some antifuses which are programmed during testing.

Figure 1 includes a preferred antifuse test structure for including on a logic array chip. Positioned around the perimeter of the chip are antifuses to be programmed during testing and before shipping. A plurality of antifuse units 1101 through 1124 comprise both programmed antifuses and logic circuitry. Positioned in the body of the chip, and represented by circuitry 101 in the canter of Figure 1, is the user-programmable part of the chip. As shown in Figure 1, in user-programmable portion 101, a plurality of horizontal and vertical interconnect line segments L11 through L20 and L41 through L56 are formed with a plurality of logic devices 9-5 through 9-6. Each interconnect line segment L11 through L20 and L41 through L56 is connected through a programming transistor to a programming voltage line VP0 through VP4. For simplicity, only a few programming transistors, and their associated pumped decoders, for example programming transistor TL41 and its associated pumped decoder DL41, are shown in Fig. 1. Many more devices, programming transistors, decoders and interconnect segments are present in a typical device. Additional description of configurable arrays and logic devices in which the present invention advantageously operates may be found in U.S. Patents 4,870,302, and 4,706,216, and in "The Programmable Gate Array Data Book", ©1989, available from Xilinx, Inc., 2100 Logic Drive, San Jose, CA 95124, all incorporated herein by reference.

Antifuses for interconnecting line segments L11 through L20 and L41 through L56 are positioned at many intersections of the line segments and are represented as a ⊕.

Also connected to one of programming voltage lines VP0 through VP4 are transistors such as TT41 for programming antifuses in the test structure. Each line segment in the test structure is connected to one of the programming voltage lines VP0 through VP4 such that opposite terminals of the same antifuse are connected to different programming lines. For simplicity, only the transistors and decoders for interconnecting test antifuse 1116-F2 are shown in Figure 1, and only transistor TT41 and decoder DT41 are labeled. However, equivalent transistors and decoders lead to each line segment of the test structure of Figure 1.

## Antifuse Programming

According to the present invention, selected ones of the antifuses at the perimeter of the chip are programmed to form a test path having a desired number of antifuses and logic devices to represent a portion of the user-programmable array. A signal is propagated along the path. After programming (at the test facility), these units will have speed characteristics representative of an operating portion of a programmed chip after programming by a user.

For the test structure to show resistance and speed characteristics similar to those of the user-programmed device, the test structure is manufactured to have characteristics as similar as possible to a user-programmed device. The preferred user-programmable device is described in the European Application and US application 07/625 732, mentioned above.

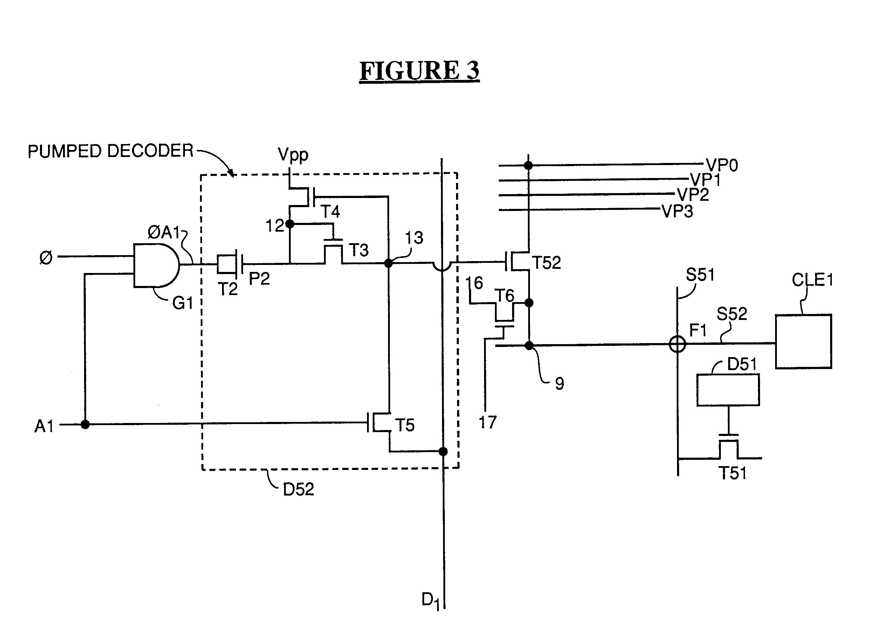

Figure 3 shows a structure for programming an antifuse as discussed in the copending application. Logic devices such as CLE1 shown in Figure 3 can be any of those shown in "The Programmable Gate Array Data Book", ibid.

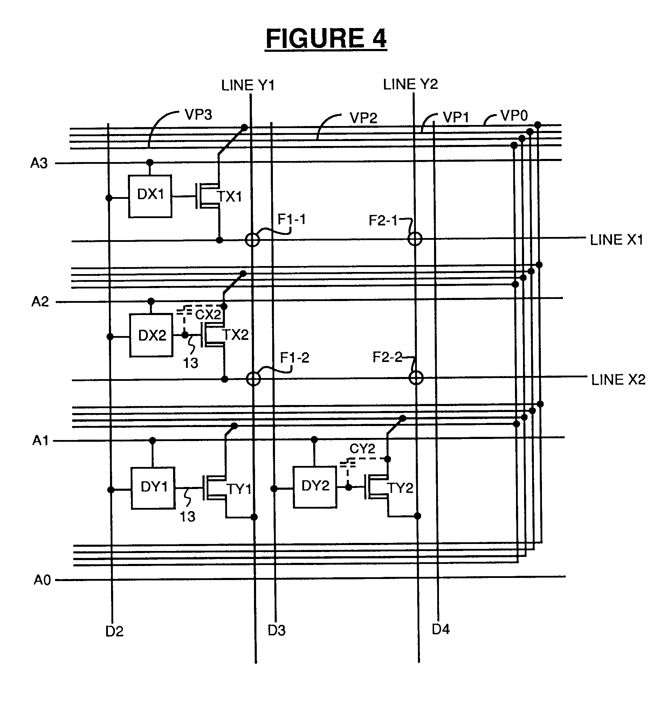

The pumped decoders of Figure 3 are addressed for turning on corresponding transistors through a circuit such as shown in Figure 4. The antifuse testing circuit of Figure 1 is addressed by the same means as the remainder of the antifuses in the logic array are addressed. In a preferred embodiment, the addressing means is then that shown in Figure 4. A complete description of the means for addressing is discussed in the copending application in connection with Figures 6a through Figure 7d of that application. Since means for programming the perimeter test structure of Figure 1 are the same as those discussed in the copending application, circuits for programming the perimeter test structure are not discussed again here.

Selecting Antifuses of the Perimeter Test Structure to be Programmed

The antifuses may be selectively programmed to generate a signal path having resistance and capacitance characteristics representative of a portion of a programmed device. The perimeter test structure includes delay circuits 1101-D through 1124-D which may be inserted into the delay path to simulate delay of the logic circuitry. Delay circuits 1101-D through 1124-D are modeled after logic devices such as 9-5 and 9-6 which are in the user-programmable portion 101 of the logic array. Delay circuits 1101-D through 1124-D may be identical to the user-programmable devices such as 9-5 and 9-6. Alternatively, in order to save space, the delay circuits may have fewer path options than the user-programmable devices they simulate but should have a path with similar capacitance and resistance as a path through a user-programmable device. Since the perimeter delay devices 1101 through 1124 mimic or simulate the user-programmable devices 9-5 and 9-6, the structure of the perimeter delay devices depends upon the structure of the user-programmable devices to be simulated. Therefore, measured resistance and delay of the test structure of Figure 1 accurately reflect the resistance and delay to be expected when the array chip is programmed by an end user. If the user-programmable logic devices have more than one configuration (for example there may be user-programmable devices interior to the chip for generating logic functions and user-programmable devices near the perimeter for input/output functions), there may be corresponding delay devices in the perimeter test structure for simulating more than one kind of logic device.

Providing the test structure of Figure 1 allows estimating resistance and delay of a programmed array chip without using up any of the user-programmable portions of the array chip.

Preferably, the test path is positioned on all four edges of the chip, as shown, though a good estimate of expected resistance and speed characteristics can also be obtained by locating a test structure anywhere in the logic array chip. In the embodiment of Figure 1, each edge of the chip can be separately tested, and the slowest edge can be detected. The slowest edge can be used to determine the speed which the user can expect. Therefore this perimeter test structure can be used for speed binning, that is, for sorting tested chips into bins according to the speed expected for a programmed chip. Chips with the highest perimeter test structure performance can be sold with a guarantee of higher performance for the entire chip.

Referring to Figure 1, a method for serially testing the four edges of the perimeter test structure comprises applying to the TSTCLK input line a square wave having a period twice the maximum acceptable delay for the path along one edge (a square wave which switches states at a rate equal to the maximum acceptable delay). If the test path delay is less than the duration of the TSTCLK logic low state, the low TSTCLK signal propagated through the delay path will arrive at the D input of flip flop FF1 before the next rising edge of the TSTCLK signal triggers the clock input of D flip flop FF1. In this case, the output of D flip flop FF1 will always be low.

Figure 1 shows programmed antifuses as black dots, and unprogrammed antifuses as ⊕. In the particular example shown, the TSTCLK signal propagates through 13 antifuses and two delay logic blocks on each edge of the array. On the first edge of the array, with the antifuses programmed as shown, the TSTCLK signal separates from the line L11 and is delayed as it passes through programmed antifuse 1101-F5, delay circuit 1101-D, antifuse 1101-F1, antifuse 1102-F4, antifuse 1102-F3, antifuse 1103-F4, antifuse 1103-F3, antifuse 1104-F4, delay circuit 1104-D, antifuse 1104-F1, antifuse 1105-F4, antifuse 1105-F3, antifuse 1106-F4 and antifuse 1106-F3 before reaching the D input of flip flop FF1. Clearly the structure allows wide choice in the delay path, both in the number of antifuses and in the number of delay devices through which the signal must pass. As long as the logical low TSTCLK signal reaches the D input of flip flop FF1 before the rising edge of TSTCLK is detected on the clock input of FF1, the Q output of flip flop FF1 will pass a steady logical low to NOR gate NOR1, which will then pass the square wave of TSTCLK to inverter IN1 and to the next edge of the chip.

Antifuses on subsequent edges of the chip are preferably but not necessarily programmed identically to those on the first edge of the chip. If all four edges of the chip are sufficiently fast, the FAIL output signal will be a square wave similar to TSTCLK, but delayed. However, if any edge inserts too much delay into the signal, the corresponding flip flop will input a high signal to the corresponding NOR gate and a steady state high signal will propagate to the FAIL output line. A steady signal indicates that one or more of the test paths was too slow.

Thus with the circuit of Figure 1, it is possible to test all logic devices, as discussed in the copending application, and additionally to make a close estimate of the programmed resistance of antifuses in the unprogrammed chip.

**Claims**

1. An antifuse test structure for estimating resistance and delay in an integrated circuit structure, the antifuse test structure comprising:
 a plurality of test antifuses;
 means for programming selected ones of the test antifuses and thereby forming a test path;

and

means for testing delay in the test path.

2. A structure as claimed in claim 1 wherein the means for testing delay in the test path comprises means for applying a test signal to the test path, and for determining whether the test signal propagates through the test path within an acceptable time delay.

3. A structure as claimed in claim 2 in which the means for applying and determining comprises means for applying a test signal which switches states after a time equal to a maximum acceptable delay, and a flip flop which receives the test signal on its input terminal, and the test signal as propagated through the test path on its clock terminal, the flip flop providing a constant value signal if the test path provides a delay less than the maximum acceptable delay.

4. A structure as claimed in claim 1, 2 or 3 wherein the test path includes at least one delay circuit, whereby the combination of the delay circuit and the test antifuses simulates delay occurring in portions of the integrated circuit structure not part of the antifuse test structure.

5. A structure as claimed in claim 1, 2, 3 or 4 wherein the antifuse test structure is positioned along at least one edge of the integrated circuit structure.

6. A structure as claimed in claim 5 wherein the antifuse test structure is positioned along four edges of the integrated circuit structure.

7. A structure as claimed in claim 6 formed as four edge units serially connected, one unit being positioned along each edge of the integrated circuit structure, each of the edge units comprising a test path and means for testing delay in the test path, such that the test signal must propagate through each of said test paths within an acceptable time delay.

8. A method of estimating resistance and delay in an integrated circuit structure, the method comprising:

programming selected ones of a plurality of test antifuses to form a test path and testing delay in the test path.

FIGURE 1

EP 0 489 571 A2

**FIGURE 2**

EP 0 489 571 A2

**FIGURE 3**

# FIGURE 4